# EUROPEAN PATENT APPLICATION

(11) **EP 2 921 533 A1**
(43) Date of publication of application: **23.09.2015**
(21) Application number: 14001019.0
(22) Date of filing: 20.03.2014
(51) Int. Cl.: C09C 3/08, C09C 3/10, C03C 17/28, H01B 1/22, H01L 31/0224

(54) **Inorganic oxide particles having organic coating**

(71) Applicant: Heraeus Precious Metals North America Conshohocken LLC, West Conshohocken, PA 19428 (US)
(72) Inventor: Berube, Gregory, Nashua, New Hampshire 03062 (US); GUO, Cuiwen, Horsham, Pennsylvania 19044 (US); Wang, Lei, Conshohocken, Pennsylvania 19428 (US); Kapp, David, Gibsonia, Pennsylvania 15044 (US)
(74) Representative: Brand, Normen

(57) **Abstract**

An inorganic oxide particle having an organic coating is provided. The invention also provides a process for preparing an organic coated inorganic oxide particle comprising forming an organic coating on the inorganic oxide particle. Specifically, a process for preparing an organic coated inorganic oxide particle, comprising obtaining a mixture of at least one inorganic oxide particle and at least one coating agent in at least one solvent, agitating the mixture, and removing the solvent is provided. The invention also provides an inorganic oxide particle prepared by the claimed processes, as well as the use of the inorganic oxide particle in a composition. A composition comprising the inorganic oxide particles of the invention, such as an electroconductive composition comprising the inorganic oxide particles, conductive metallic particles, and an organic vehicle is also provided.

## Description

### Technical Field

This invention relates to an inorganic oxide particle having an organic coating. Specifically, the coated particles may be incorporated into a composition, such as an electroconductive composition, to improve printability and aged stability. The invention also relates to processes for preparing the coated particles.

### Background

Solar cells are devices that convert the energy of light into electricity using the photovoltaic effect. Solar power is an attractive green energy source because it is sustainable and produces only non-polluting by-products. In operation, when light hits a solar cell, a fraction of the incident light is reflected by the surface and the remainder is transmitted into the solar cell. The photons of the transmitted light are absorbed by the solar cell, which is usually made of a semiconducting material such as silicon. The energy from the absorbed photons excites electrons of the semiconducting material from their atoms, generating electron-hole pairs. These electron-hole pairs are then separated by p-n junctions and collected by conductive electrodes which are applied on the solar cell surface. In this way, electricity may be conducted between interconnected solar cells.

Solar cells typically have electroconductive compositions applied to both their front and back surfaces which, when fired, form electrodes. While any known application methods may be used, these pastes are often applied to the substrate via screen printing. A typical electroconductive composition contains metallic particles, an inorganic component and an organic vehicle. The composition of the organic vehicle may have an impact on the viscosity of the composition, thereby affecting the paste's printability, which in turn affects the performance of the solar cell. One problem associated with known paste compositions is that screen clogging often occurs during screen printing of the composition onto the substrate. Such clogging decreases the amount of paste transfer through the screen, which decreases the printed line uniformity and electrical performance of the solar cell. Another problem associated with known paste compositions is the lack of aged stability, or the ability to maintain a uniform composition over an extended period of time. Paste components sometimes have a tendency to separate out of the composition mixture when shelved for an extended period of time. As such, paste compositions with improved aged stability are desired.

Accordingly, there is a need for electroconductive compositions which are more easily screen printed and which reduce screen clogging so as to improve the uniformity of the printed lines and thus improve solar cell performance. Electroconductive compositions with improved aged stability are also desired.

### Summary

The invention provides an inorganic oxide particle having an organic coating. In one embodiment, the coated particles are incorporated into an electroconductive composition. The organic coating improves printability and aged stability of the electroconductive composition.

One embodiment of the invention relates to an inorganic oxide particle having an organic coating.

The invention also provides a process for preparing an organic coated inorganic oxide particle comprising forming an organic coating on the inorganic oxide particle.

The invention further provides a process for preparing an organic coated inorganic oxide particle, comprising obtaining a mixture of at least one inorganic oxide particle and at least one coating agent in at least one solvent, agitating the mixture, and removing the solvent.

### Detailed Description

The organic coated inorganic oxide particles of the invention may be useful as components in any number of applications, including, but not limited to, electroconductive compositions, resistor compositions, dielectric compositions, soldering compositions, decorative compositions, and sealing compositions. Such compositions may be used to form, for example, electric circuits, solar cells, LEDs, displays, capacitors, resistors, other known electronic components, and any combinations thereof.

### Inorganic Oxide Particles

According to one embodiment, the inorganic oxide particles comprise particles of glass frits, ceramics, crystalline phases or compounds, a mixture of amorphous, partially crystalline, and/or crystalline phases or compounds, and/or mixtures thereof, together referred to as the inorganic reaction system (IRS). In one embodiment, the IRS comprises glass frit particles. In another embodiment, the IRS comprises at least one of particles of glass frit(s), oxides, and salts. The particles may be formed of, for example, oxides of magnesium, nickel, tellurium, tungsten, zinc, gadolinium, antimony, cerium, zirconium, titanium, manganese, lead, tin, ruthenium, silicon, cobalt, iron, copper, bismuth, boron, and chromium, or any combination of at least two thereof, compounds which can generate those metal oxides upon firing, or a mixture of at least two of the aforementioned metals, a mixture of at least two of the aforementioned oxides, a mixture of at least two of the aforementioned compounds which can generate those metal oxides on firing, or mixtures of two or more of any of the above mentioned. Other materials which may be used to form the inorganic oxide particles include, but are not limited to, germanium oxide, vanadium oxide, molybdenum oxide, niobium oxide, indium oxide, other alkaline and alkaline earth metal (e.g., potassium, rubidium, caesium, calcium, strontium, and barium) compounds, rare earth oxides (e.g., lanthanum oxide, cerium oxides), and phosphorus oxides. According to one embodiment, the inorganic particles are lead-based and may include lead oxide. In another embodiment, the inorganic component may be lead-free. The lead-free inorganic particles may be formed of any of the above-mentioned oxides or compounds. The term "lead-free" indicates that the inorganic component has less than 0.5 wt% lead, based upon 100% total weight of the glass frit.

Other suitable types of glass frit particles and their preparation are disclosed in U.S. Patent Publication Nos. 2013/0269773, 2013/0269772, 2013/0270489, 2012/0270366, 2012/0138142, and 2012/0174974 and U.S. Patent No. 8,309,844.

It is well known to the person skilled in the art that inorganic particles can exhibit a variety of shapes, sizes, and surface areas. Some examples of shapes include, but are not limited to, spherical, angular, elongated (rod or needle like) and flat (sheet like). Inorganic particles may also be present as a combination of particles with different shapes. One way to characterize such shapes is through the following parameters: length, width and thickness. In the context of the invention, the length of a particle is given by the length of the longest spatial displacement vector, both endpoints of which are contained within the particle. The width of a particle is given by the length of the longest spatial displacement vector perpendicular to the length vector defined above both endpoints of which are contained within the particle. The thickness of a particle is given by the length of the longest spatial displacement vector perpendicular to both the length vector and the width vector, both defined above, both endpoints of which are contained within the particle.

In one embodiment, inorganic particles with shapes as uniform as possible are preferred (i.e. shapes in which the ratios relating any two of the length, the width and the thickness are as close as possible to 1; preferably at least 0.7, more preferably at least 0.8, and most preferably at least 0.9, and preferably no more than about 1.5, preferably no more than about 1.3, and most preferably no more than about 1.2). Examples of preferred shapes for the inorganic particles in this embodiment are spheres and cubes, or combinations thereof, or combinations of one or more thereof with other shapes. In another embodiment, inorganic particles are preferred which have a shape of low uniformity, preferably with at least one of the ratios relating the dimensions of length, width and thickness being above about 1.5, more preferably above about 3 and most preferably above about 5. Preferred shapes according to this embodiment are flake shaped, rod or needle shaped, or a combination of flake shaped, rod or needle shaped with other shapes.

Another parameter characterizing the inorganic particles is the median particle diameter d₅₀. The d₅₀ is the median diameter or the medium value of the particle size distribution. It is the value of the particle diameter at 50% in the cumulative distribution. A Horiba LA-910 Laser Diffraction Particle Size Analyzer connected to a computer with the LA-910 software program is used to determine the particle size distribution of the inorganic particles. The relative refractive index of the inorganic particle is chosen from the LA-910 manual and entered into the software program. The test chamber is filled with deionized water to the proper fill line on the tank. The solution is then circulated by using the circulation and agitation functions in the software program. After one minute, the solution is drained. This is repeated an additional time to ensure the chamber is clean of any residual material. The chamber is then filled with deionized water for a third time and allowed to circulate and agitate for one minute. Any background particles in the solution are eliminated by using the blank function in the software. Ultrasonic agitation is then started, and the inorganic particles are slowly added to the solution in the test chamber until the transmittance bars are in the proper zone in the software program. Once the transmittance is at the correct level, the laser diffraction analysis is run and the particle size distribution of the glass is measured and given as d₅₀.

It is preferred that the median particle size d₅₀ of the inorganic particles be at least about 0.1 µm, and preferably at least about 0.3 µm. At the same time, it is preferred that the d₅₀ of the inorganic particles be no more than about 50 µm, more preferably no more than about 10 µm, more preferably no more than about 4 µm, and most preferably no more than about 2 µm.

Another characteristic of inorganic particles is the specific surface area. Specific surface area is a property of solids equal to the total surface area of the material per unit mass, solid, or bulk volume, or cross sectional area. It is defined either by surface area divided by mass (with units of m²/g) or surface area divided by volume (units of m⁻¹). The lowest value for the specific surface area of a particle is embodied by a sphere with a smooth surface. The less uniform and uneven a shape is, the higher its specific surface area will be. As set forth herein, the higher the specific surface area, the higher the risk of screen clogging.

The specific surface area (surface area per unit mass) may be measured by the BET (Brunauer-Emmett-Teller) method, which is known in the art. Specifically, BET measurements are made in accordance with DIN ISO 9277:1995. A Monosorb Model MS-22 instrument (manufactured by Quantachrome Instruments), which operates according to the SMART method (Sorption Method with Adaptive dosing Rate), is used for the measurement. As a reference material, aluminum oxide (available from Quantachrome Instruments as surface area reference material Cat. No. 2003) is used. Samples are prepared for analysis in the built-in degas station. Flowing gas (30% N₂ and 70% He) sweeps away impurities, resulting in a clean surface upon which adsorption may occur. The sample can be heated to a user-selectable temperature with the supplied heating mantle. Digital temperature control and display are mounted on the instrument front panel. After degassing is complete, the sample cell is transferred to the analysis station. Quick connect fittings automatically seal the sample cell during transfer, and the system is then activated to commence the analysis. A dewar flask filled with coolant is manually raised, immersing the sample cell and causing adsorption. The instrument detects when adsorption is complete (2-3 minutes), automatically lowers the dewar flask, and gently heats the sample cell back to room temperature using a built-in hot-air blower. As a result, the desorbed gas signal is displayed on a digital meter and the surface area is directly presented on a front panel display. The entire measurement (adsorption and desorption) cycle typically requires less than six minutes. The technique uses a high sensitivity, thermal conductivity detector to measure the change in concentration of an adsorbate/inert carrier gas mixture as adsorption and desorption proceed. When integrated by the on-board electronics and compared to calibration, the detector provides the volume of gas adsorbed or desorbed. For the adsorptive measurement, N₂ 5.0 with a molecular cross-sectional area of 0.162 nm² at 77K is used for the calculation. A one-point analysis is performed and a built-in microprocessor ensures linearity and automatically computes the sample's BET surface area in m²/g.

In one embodiment, the inorganic particles have a specific surface area of at least about 0.25 m²/g, preferably at least about 0.5 m²/g, and most preferably at least about 1 m²/g. At the same time, it is preferred that the specific surface area be no more than about 100 m²/g, preferably no more than about 20 m²/g, and most preferably no more than about 10 m²/g.

### Organic Coating

The inorganic oxide particles are preferably coated with an organic coating. In one embodiment, the organic coating has the ability to form hydrogen bonds or an organic compound having at least one group containing a heteroatom. For example, the organic coating may be formed of an organic compound that has a moiety that will associate with the inorganic particle, such as, for example, a group containing a heteroatom (e.g., oxygen, nitrogen, sulphur, or phosphorus), a carbon-carbon double bond, or a carbon-carbon triple bond. The organic compound may be a wetting and/or dispersing agent, such as a dispersant having an acid functional group. Suitable organic compounds include, but are not limited to, amines, fatty acids (such as saturated fatty acids including C₈-C₂₄ saturated fatty acids (e.g., stearic acid) and unsaturated fatty acids including unsaturated C₈-C₂₄ fatty acids (e.g., oleic acid)), copolymers with acidic groups, acrylic acids, phosphoric acid esters, polymer salts having an acid group, carboxylic acid esters having a hydroxyl group, fatty amides, carboxylic acids, phosphonic acids, organic acid anhydrides, acrylic copolymers, phosphates of a copolymer, alkyl ammonium salts of a block copolymer, modified acrylic block copolymers and their salts, and any combination thereof.

Suitable phosphoric acid esters include, but are not limited to, a phosphoric acid ester of the formula (OH)₃₋ₙ-P(=O)-(O-R)ₙ where the ester group R is an aliphatic, cycloaliphatic and/or aromatic moiety having no Zerewitinoff hydrogen, containing at least one ether oxygen atom (-O-) and at least one carboxylic acid ester group (-COO-) and/or urethane group (-NCOO-), and having an average molecular weight Mₙ of 200 to 10,000, where the hydrogen atoms may be partially replaced by halogens and the ratio of the number of ether oxygen atoms to the number of carboxy acid ester groups and/or urethane groups in the molecule (or in every group R) is in the range from 1:20 to 20:1, and n represents 1 or 2. Such suitable phosphoric acid esters are described in U.S. Patent No. 5,130,463. One preferred organic compound is DISPERBYK-110 commercially available from BYK Additives & Instrument of Louisville, KY.

In another preferred embodiment, the organic coating is an acrylic acid.

In another embodiment, the organic coating is hydrophobic.

### Process of Coating Inorganic Oxide Particles

To prepare the inorganic oxide particles, the desired coating material (coating agent) is used to form an organic coating on the particles. In one embodiment, at least one coating agent is combined with at least one solvent and the inorganic particles. Any solvent known in the art may be used, including, but not limited to, water, alcohols, ketones, ethers, esters, amides, amines, carboxylic acids, hydrocarbons, and any combination of at least two thereof.

This mixture is then agitated so as to sufficiently coat the inorganic particles with the coating (e.g., 15 minutes). The agitation may be performed using a stirred vessel, ball mill or media mill at a temperature of at least about 5°C. At the same time, the agitation preferably occurs at a temperature of no more than about 120°C. The mixture is then poured onto a tray such that the solvent component may be removed from the mixture. In one embodiment, the mixture is dried at a temperature of at least about 25°C so as to evaporate the excess solvent component. At the same time, the mixture is preferably dried at a temperature of no more than about 200°C.

To determine the amount of organic coating on the inorganic oxide particles, the amount of heteroatoms per unit specific surface area of the inorganic oxide particle is calculated. To determine the amount of heteroatoms, which is provided in units of parts per million on a weight basis (ppm), a means for analyzing the heteroatoms, such as LECO analysis, is utilized. The specific surface area of the inorganic particle in m²/g is determined as set forth above. Preferably, the amount of heteroatoms per unit specific surface area of the inorganic oxide particle is at least 10 ppm/(m²/g), preferably at least 50 ppm (m²/g), and most preferably at least 100 ppm/(m²/g).

### Electroconductive Composition

In one embodiment, the organic coated inorganic oxide particles may be incorporated into an electroconductive composition used to form electrodes on a solar cell. The electrodes provide the path by which conductivity occurs between solar cells. An electroconductive composition preferably includes conductive metallic particles, the coated inorganic particles of the invention, and an organic vehicle.

The inorganic component of the electroconductive composition acts as an adhesion media, facilitating bonding between the conductive metallic particles and the silicon substrate, thereby providing reliable electrical contact. Specifically, the inorganic component etches through the surface layers (e.g., antireflective layer) of the silicon substrate, such that effective electrical contact can be made between the electroconductive composition and the silicon wafer.

Coarse particles or agglomerates of the inorganic component may have a detrimental effect on printability as they tend to increase the occurrence of screen clogging (clogging of the openings of the screen used during printing). Inorganic particles typically have high specific surface areas (as compared to other particles used in the paste), and therefore require a significant amount of organic vehicle to provide adequate wetting of the particles. Improperly wetted particles may result in screen clogging. When clogging occurs, the paste does not transfer through the screen, printed lines become less uniform, and solar cell efficiency decreases. The electroconductive compositions of the invention have good printability and form uniform, or substantially uniform, printed lines.

The printability of an electroconductive composition is determined by a number of variables, as set forth more fully herein, and generally refers to the ability of the composition to be screen printed to form uniform lines. One way to characterize the uniformity of a printed line is by its line definition, which can be determined by calculating the aspect ratio (ratio between height and width) of the printed line. The higher the aspect ratio, the better the line uniformity.

Without being bound by any particular theory, the organic coating on the inorganic oxide particles is believed to improve the dispersibility of the inorganic particles in the organic vehicle, thus stabilizing the inorganic particles in the paste so as to reduce the occurrence of clogging and improve printability.

According to a preferred embodiment, the inorganic oxide particles used in the electroconductive composition are glass frits. Preferred glass frits are particles of amorphous or partially crystalline solids which exhibit a glass transition. Suitable glass frit materials are set forth more fully herein. The glass transition temperature (Tg) is the temperature at which an amorphous substance transforms from a rigid solid to a partially mobile undercooled melt upon heating. The glass transition temperature T_{g} may be determined using a DSC apparatus SDT Q600 (commercially available from TA Instruments) which simultaneously records differential scanning calorimetry (DSC) and thermogravimetric analysis (TGA) curves. The instrument is equipped with a horizontal balance and furnace with a platinum/platinum-rhodium (type R) thermocouple. The sample holders used are aluminum oxide ceramic crucibles with a capacity of about 40-90 µl. For the measurements and data evaluation, the measurement software Q Advantage; Thermal Advantage Release 5.4.0 and Universal Analysis 2000, version 4.5A Build 4.5.0.5 is applied respectively. As pan for reference and sample, aluminum oxide pan having a volume of about 85 µl is used. An amount of about 10-50 mg of the sample is weighted into the sample pan with an accuracy of 0.01 mg. The empty reference pan and the sample pan are placed in the apparatus, the oven is closed and the measurement started. A heating rate of 10 K/min is employed from a starting temperature of 25 °C to an end temperature of 1000 °C. The balance in the instrument is always purged with nitrogen (N₂ 5.0) and the oven is purged with synthetic air (80% N₂ and 20% O₂ from Linde) with a flow rate of 50 ml/min. The first step in the DSC signal is evaluated as glass transition using the software described above, and the determined onset value is taken as the temperature for T_{g}.

Preferably, the Tg of the glass frit is below the desired firing temperature of the electroconductive composition. According to the invention, preferred glass frits have a T_{g} of at least about 200°C, and preferably at least about 250°C. At the same time, preferred glass frits have a T_{g} of no more than about 700°C, preferably no more than about 650°C, and most preferably no more than about 500°C.

According to one embodiment, the electroconductive composition includes at least about 0.1 wt% inorganic component, preferably at least about 0.5 wt%, and most preferably at least about 0.8 wt%, based upon 100% total weight of the composition. At the same time, the paste preferably includes no more than about 15 wt% inorganic component, preferably no more than about 10 wt%, and most preferably no more than about 5 wt%, based upon 100% total weight of the composition.

In one embodiment, the organic coating is at least about 0.05 wt% of the composition, preferably at least about 0.25 wt%, and most preferably at least about 0.5 wt%, based upon 100% total weight of the composition. At the same time, the organic coating is preferably no more than about 10 wt%, preferably no more than about 7 wt%, and most preferably no more than about 4 wt%, based upon 100% total weight of the composition.

### Organic Vehicle

Preferred organic vehicles are solutions, emulsions or dispersions based on one or more solvents, preferably organic solvent(s), which ensure that the components of the electroconductive composition are present in a dissolved, emulsified or dispersed form. Preferred organic vehicles are those which provide optimal stability of the components of the electroconductive composition and which provide the paste with suitable printability.

In one embodiment, the organic vehicle comprises an organic solvent and one or more of a binder (e.g., a polymer), a surfactant and a thixotropic agent, or any combination thereof. For example, in one embodiment, the organic vehicle comprises one or more binders in an organic solvent.

Preferred binders are those which contribute to the formation of an electroconductive composition with favorable stability, printability, and viscosity. All binders which are known in the art, and which are considered to be suitable in the context of this invention, may be employed as the binder in the organic vehicle. Preferred binders (which often fall within the category termed "resins") are polymeric binders, monomeric binders, and binders which are a combination of polymers and monomers. Polymeric binders can also be copolymers wherein at least two different monomeric units are contained in a single molecule. Preferred polymeric binders are those which carry functional groups in the polymer main chain, those which carry functional groups off of the main chain and those which carry functional groups both within the main chain and off of the main chain. Preferred polymers carrying functional groups in the main chain are for example polyesters, substituted polyesters, polycarbonates, substituted polycarbonates, polymers which carry cyclic groups in the main chain, poly-sugars, substituted poly-sugars, polyurethanes, substituted polyurethanes, polyamides, substituted polyamides, phenolic resins, substituted phenolic resins, copolymers of the monomers of one or more of the preceding polymers, optionally with other co-monomers, or a combination of at least two thereof. According to one embodiment, the binder may be polyvinyl butyral or polyethylene. Preferred polymers which carry cyclic groups in the main chain are for example polyvinylbutylate (PVB) and its derivatives and poly-terpineol and its derivatives or mixtures thereof. Preferred poly-sugars are for example cellulose and alkyl derivatives thereof, preferably methyl cellulose, ethyl cellulose, hydroxyethyl cellulose, propyl cellulose, hydroxypropyl cellulose, butyl cellulose and their derivatives and mixtures of at least two thereof. Other preferred polymers are cellulose ester resins, e.g., cellulose acetate propionate, cellulose acetate butyrate, and any combinations thereof. Preferred polymers which carry functional groups off of the main polymer chain are those which carry amide groups, those which carry acid and/or ester groups, often called acrylic resins, or polymers which carry a combination of aforementioned functional groups, or a combination thereof. Preferred polymers which carry amide off of the main chain are for example polyvinyl pyrrolidone (PVP) and its derivatives. Preferred polymers which carry acid and/or ester groups off of the main chain are for example polyacrylic acid and its derivatives, polymethacrylate (PMA) and its derivatives or polymethylmethacrylate (PMMA) and its derivatives, or a mixture thereof. Preferred monomeric binders are ethylene glycol based monomers, terpineol resins or rosin derivatives, or a mixture thereof. Preferred monomeric binders based on ethylene glycol are those with ether groups, ester groups or those with an ether group and an ester group, preferred ether groups being methyl, ethyl, propyl, butyl, pentyl hexyl and higher alkyl ethers, the preferred ester group being acetate and its alkyl derivatives, preferably ethylene glycol monobutylether monoacetate or a mixture thereof. Alkyl cellulose, preferably ethyl cellulose, its derivatives and mixtures thereof with other binders from the preceding lists of binders or otherwise are the most preferred binders in the context of the invention. The binder may be present in an amount of at least about 0.1 wt%, preferably at least about 0.5 wt%, and most preferably at least about 1 wt%, based upon 100% total weight of the organic vehicle. At the same time, the binder may be present in an amount of no more than about 25 wt%, preferably no more than about 15 wt%, and more preferably no more than about 12 wt%, based upon 100% total weight of the organic vehicle.

Preferred solvents are components which are removed from the paste to a significant extent during firing. Preferably, they are present after firing with an absolute weight reduced by at least about 80% compared to before firing, preferably reduced by at least about 95% compared to before firing. Preferred solvents are those which contribute to favorable viscosity, printability, stability and sintering characteristics. All solvents which are known in the art, and which are considered to be suitable in the context of this invention, may be employed as the solvent in the organic vehicle. Preferred solvents are those which exist as a liquid under standard ambient temperature and pressure (SATP) (298.15 K, 25 °C, 77 °F), 100 kPa (14.504 psi, 0.986 atm), preferably those with a boiling point above about 90°C and a melting point above about -20°C. Preferred solvents are polar or non-polar, protic or aprotic, aromatic or non-aromatic. Preferred solvents are mono-alcohols, di-alcohols, poly-alcohols, mono-esters, di-esters, poly-esters, mono-ethers, di-ethers, poly-ethers, solvents which comprise at least one or more of these categories of functional group, optionally comprising other categories of functional group, preferably cyclic groups, aromatic groups, unsaturated bonds, alcohol groups with one or more O atoms replaced by heteroatoms, ether groups with one or more O atoms replaced by heteroatoms, esters groups with one or more O atoms replaced by heteroatoms, and mixtures of two or more of the aforementioned solvents. Preferred esters in this context are di-alkyl esters of adipic acid, preferred alkyl constituents being methyl, ethyl, propyl, butyl, pentyl, hexyl and higher alkyl groups or combinations of two different such alkyl groups, preferably dimethyladipate, and mixtures of two or more adipate esters. Preferred ethers in this context are diethers, preferably dialkyl ethers of ethylene glycol, preferred alkyl constituents being methyl, ethyl, propyl, butyl, pentyl, hexyl and higher alkyl groups or combinations of two different such alkyl groups, and mixtures of two diethers. Preferred alcohols in this context are primary, secondary and tertiary alcohols, preferably tertiary alcohols, terpineol and its derivatives being preferred, or a mixture of two or more alcohols. Preferred solvents which combine more than one different functional groups are 2,2,4-trimethyl-1,3-pentanediol monoisobutyrate, often called texanol, and its derivatives, 2-(2-ethoxyethoxy)ethanol, often known as carbitol, its alkyl derivatives, preferably methyl, ethyl, propyl, butyl, pentyl, and hexyl carbitol, preferably hexyl carbitol or butyl carbitol, and acetate derivatives thereof, preferably butyl carbitol acetate, or mixtures of at least two of the aforementioned. The organic solvent may be present in an amount of at least about 60 wt%, and more preferably at least about 70 wt%, and most preferably at least about 85 wt%, based upon 100% total weight of the organic vehicle. At the same time, the organic solvent may be present in an amount of no more than about 99 wt%, and more preferably no more than about 95 wt%, based upon 100% total weight of the organic vehicle.

The organic vehicle may also comprise one or more surfactants, thixotropic agents, and/or additives. Preferred surfactants are those which contribute to the formation of an electroconductive composition with favorable stability, printability, viscosity and sintering properties. All surfactants which are known in the art, and which are considered to be suitable in the context of this invention, may be employed as the surfactant in the organic vehicle. Preferred surfactants are those based on linear chains, branched chains, aromatic chains, fluorinated chains, siloxane chains, polyether chains and combinations thereof. Preferred surfactants include, but are not limited to, single chained, double chained or poly chained polymers. Preferred surfactants may have non-ionic, anionic, cationic, amphiphilic, or zwitterionic heads. Preferred surfactants may be polymeric and monomeric or a mixture thereof. Preferred surfactants may have pigment affinic groups, preferably hydroxyfunctional carboxylic acid esters with pigment affinic groups (e.g., DISPERBYK®-108, manufactured by BYK USA, Inc.), acrylate copolymers with pigment affinic groups (e.g., DISPERBYK®-116, manufactured by BYK USA, Inc.), modified polyethers with pigment affinic groups (e.g., TEGO® DISPERS 655, manufactured by Evonik Tego Chemie GmbH), other surfactants with groups of high pigment affinity (e.g., TEGO® DISPERS 662 C, manufactured by Evonik Tego Chemie GmbH). Other preferred polymers not in the above list include, but are not limited to, polyethylene oxide, polyethylene glycol and its derivatives, and alkyl carboxylic acids and their derivatives or salts, or mixtures thereof. The preferred polyethylene glycol derivative is poly(ethyleneglycol)acetic acid. Preferred alkyl carboxylic acids are those with fully saturated and those with singly or poly unsaturated alkyl chains or mixtures thereof. Preferred carboxylic acids with saturated alkyl chains are those with alkyl chains lengths in a range from about 8 to about 20 carbon atoms, preferably C₉H₁₉COOH (capric acid), C₁₁H₂₃COOH (Lauric acid), C₁₃H₂₇COOH (myristic acid) C₁₅H₃₁COOH (palmitic acid), C₁₇H₃₅COOH (stearic acid), or salts or mixtures thereof. Preferred carboxylic acids with unsaturated alkyl chains are C₁₈H₃₄O₂ (oleic acid) and C₁₈H₃₂O₂ (linoleic acid). The preferred monomeric surfactant is benzotriazole and its derivatives. If present, the surfactant may be at least about 0.01 wt%, based upon 100% total weight of the organic vehicle. At the same time, the surfactant is preferably no more than about 10 wt%, preferably no more than about 8 wt%, and more preferably no more than about 6 wt%, based upon 100% total weight of the organic vehicle.

The organic vehicle may also comprise a thixotropic agent. Any thixotropic agent known to one having ordinary skill in the art may be used with the organic vehicle of the invention. For example, without limitation, thixotropic agents may be derived from natural origin, e.g., castor oil, or they may be synthesized. Preferred thixotropic agents are carboxylic acid derivatives, preferably fatty acid derivatives or combinations thereof. Commercially available thixotropic agents, such as, for example, Thixotrol^{®} MAX, may also be used. According to a preferred embodiment, the organic vehicle comprises at least about 5 wt% thixotropic agent, and preferably at least about 8 wt%, based upon 100% total weight of the organic vehicle. At the same time, the organic vehicle preferably includes no more than about 15 wt% thixotropic agent, preferably no more than about 13 wt%, based upon 100% total weight of the organic vehicle.

Preferred additives in the organic vehicle are those materials which are distinct from the aforementioned components and which contribute to favorable properties of the electroconductive composition, such as advantageous viscosity, printability, and stability characteristics. Additives known in the art, and which are considered to be suitable in the context of the invention, may be used. Preferred additives include, but are not limited to, viscosity regulators, stabilizing agents, inorganic additives, thickeners, emulsifiers, dispersants and pH regulators. Preferred thixotropic agents include, but are not limited to, carboxylic acid derivatives, preferably fatty acid derivatives or combinations thereof. Preferred fatty acid derivatives include, but are not limited to, C₉H₁₉COOH (capric acid), C₁₁H₂₃COOH (Lauric acid), C₁₃H₂₇COOH (myristic acid) C₁₅H₃₁COOH (palmitic acid), C₁₇H₃₅COOH (stearic acid) C₁₈H₃₄O₂ (oleic acid), C₁₈H₃₂O₂ (linoleic acid) and combinations thereof. A preferred combination comprising fatty acids in this context is castor oil. Where present, such additives are preferably no more than about 15 wt%, based upon 100% total weight of the organic vehicle.

The viscosity of the electroconductive composition typically has an effect on the printability of the composition. If the viscosity is too high, the paste may not transfer well through the screen mesh and clogging may occur. If the viscosity is too low, the paste may be too fluid, causing the printing lines to spread and the aspect ratio to decrease. The viscosity may be measured using a Brookfield® DV-III HBT Ultra Programmable rheometer at a suitable speed. Specifically, the sample is measured in a 6R utility cup using a SC4-14 spindle, and the measurement is taken after one minute at 1 RPM. According to one embodiment, the viscosity of the electroconductive composition is at least 100 kcPs, preferably at least about 120 kcPs. At the same time, the viscosity is preferably no more than about 250 kcPs, preferably no more than about 220 kcPs.

In one embodiment, the organic vehicle is present in the electroconductive composition in an amount of at least about 0.01 wt%, preferably at least about 1 wt%, and most preferably at least about 5 wt%, based upon 100% total weight of the composition. At the same time, the organic vehicle is preferably no more than about 70 wt%, preferably no more than about 55 wt%, and most preferably no more than about 20 wt%, based upon 100% total weight of the composition.

### Conductive Metallic Particles

The electroconductive composition also comprises conductive metallic particles. Conductive metallic particles are those which exhibit optimal conductivity and which effectively sinter upon firing, such that they yield electrodes with high conductivity. Conductive metallic particles known in the art suitable for use in forming solar cell electrodes are preferred. Preferred metallic particles include, but are not limited to, elemental metals, alloys, metal derivatives, mixtures of at least two metals, mixtures of at least two alloys or mixtures of at least one metal with at least one alloy.

Metals which may be employed as the metallic particles include at least one of silver, copper, gold, aluminum, nickel, platinum, palladium, molybdenum, and any mixtures or alloys of at least two thereof. In a preferred embodiment, the metallic particles are silver. The silver may be present as elemental silver, a silver alloy, or silver derivate. Suitable silver derivatives include, for example, silver alloys and/or silver salts, such as silver halides (e.g., silver chloride), silver oxide, silver nitrate, silver acetate, silver trifluoroacetate, silver orthophosphate, and combinations thereof. In another embodiment, the metallic particles may comprise a metal or alloy coated with one or more different metals or alloys, for example silver particles coated with aluminum or copper particles coated with silver.

The metallic particles may be present with a surface coating, either organic or inorganic. Any such coating known in the art, and which is considered to be suitable in the context of the invention, may be employed on the metallic particles. Preferred organic coatings are those coatings which promote dispersion into the organic vehicle, such as those set forth herein as used on the inorganic particles. Preferred inorganic coatings are those coatings which regulate sintering and promote adhesive performance of the resulting electroconductive composition. If such a coating is present, it is preferred that the coating correspond to no more than about 5 wt%, preferably no more than about 3 wt%, and most preferably no more than about 1.5 wt%, based on 100% total weight of the metallic particles.

The conductive particles may exhibit shapes and ratios relating any two of the length, width, and thickness that are similar to those of the inorganic component, as set forth herein.

It is preferred that the median particle diameter d₅₀ of the metallic particles be at least about 0.1 µm, and preferably at least about 0.3 µm. At the same time, the d₅₀ is preferably no more than about 10 µm, preferably no more than about 8 µm, and most preferably no more than about 5 µm.

According to one embodiment, the metallic particles may have a specific surface area of at least about 0.1 m²/g, and preferably at least about 0.15 m²/g. At the same time, the specific surface area is preferably no more than 6 m²/g, more preferably no more than about 5 m²/g, and most preferably no more than about 4 m²/g.

The electroconductive composition may comprise at least 30 wt% metallic particles, preferably at least 40 wt%, more preferably at least 70 wt%, and most preferably at least 80 wt%, based upon 100% total weight of the composition. At the same time, the electroconductive composition preferably includes no more than about 99 wt% metallic particles, preferably no more than about 95 wt%, based upon 100% total weight of the composition.

### Additives

According to another embodiment, the electroconductive composition may include additives distinct from the conductive particles, the coated inorganic oxide particles, and the organic vehicle. Preferred additives contribute to increased performance of the electroconductive composition, of the electrodes produced thereof, or of the resulting solar cell. All additives known in the art may be employed as additives in the electroconductive composition. Preferred additives include, but are not limited to, thixotropic agents, viscosity regulators, emulsifiers, stabilizing agents or pH regulators, inorganic additives, thickeners and dispersants, or a combination of at least two thereof. Inorganic additives are most preferred. Preferred inorganic additives include, but are not limited to, alkaline and alkaline earth metals, transition metals, such as nickel, zirconium, titanium, manganese, tin, ruthenium, cobalt, iron, copper and chromium tungsten, molybdenum, zinc; post-transition metals such as boron, silicon, germanium, tellurium, gadolinium, lead, bismuth, antimony, rare earth metals, such as lanthanum, cerium, oxides, mixed metal oxides, complex compounds, or amorphous or partially crystallized glasses formed from those oxides , or any combination of at least two thereof, preferably zinc, antimony, manganese, nickel, tungsten, tellurium and ruthenium, or a combination of at least two thereof, oxides thereof, compounds which can generate those metal oxides or glasses on firing, or a mixture of at least two of the aforementioned metals, a mixture of at least two of the aforementioned oxides, a mixture of at least two of the aforementioned compounds which can generate those metal oxides, mixed metal oxides, compounds or amorphous or partially glasses on firing, or mixtures of two or more of any of the above mentioned.

If present, the electroconductive composition may include at least about 0.05 wt% additive, and preferably at least about 0.1 wt%, based upon 100% total weight of the composition. At the same time, the paste preferably includes no more than about 10 wt%, preferably no more than about 5 wt%, and more preferably no more than about 2 wt% additive(s), based upon 100% total weight of the composition.

### Forming the Electroconductive Composition

To form an electroconductive composition, the coated inorganic particles are combined with the conductive metallic particles and organic vehicle using any method known in the art for preparing a paste composition. The method of preparation is not critical, as long as it results in a homogenously dispersed paste. The components can be mixed, such as with a mixer, then passed through a three roll mill, for example, to make a dispersed uniform paste.

The organic coating inorganic particles may be extracted from the electroconductive paste composition for analysis using any methods known in the art.

The electroconductive composition may be applied to at least one surface of a substrate. In one embodiment, once applied to a substrate, the electroconductive composition may be subjected to one or more thermal treatment steps (e.g., drying, curing, firing, and any combination thereof), one or more light curing steps, or both. In one embodiment, the thermal treatment steps may be conducted at a temperature of from about 20°C to about 1,000°C. Such steps are useful in forming an electric device such as those described herein.

### Solar Cells

The invention also relates to a solar cell. In one embodiment, the solar cell comprises a semiconductor substrate (e.g., a silicon wafer) and an electroconductive composition according to any of the embodiments described herein.

In another aspect, the invention relates to a solar cell prepared by a process which includes applying an electroconductive composition according to any of the embodiments described herein to a semiconductor substrate (e.g., a silicon wafer) and firing the semiconductor substrate.

### Silicon Wafer

Preferred wafers according to the invention have regions, among other regions of the solar cell, capable of absorbing light with high efficiency to yield electron-hole pairs and separating holes and electrons across a boundary with high efficiency, preferably across a p-n junction boundary. Preferred wafers according to the invention are those comprising a single body made up of a front doped layer and a back doped layer.

Preferably, the wafer comprises appropriately doped tetravalent elements, binary compounds, tertiary compounds or alloys. Preferred tetravalent elements in this context include, but are not limited to, silicon, germanium, or tin, preferably silicon. Preferred binary compounds include, but are not limited to, combinations of two or more tetravalent elements, binary compounds of a group III element with a group V element, binary compounds of a group II element with a group VI element or binary compounds of a group IV element with a group VI element. Preferred combinations of tetravalent elements include, but are not limited to, combinations of two or more elements selected from silicon, germanium, tin or carbon, preferably SiC. The preferred binary compounds of a group III element with a group V element is GaAs. According to a preferred embodiment of the invention, the wafer is silicon. The foregoing description, in which silicon is explicitly mentioned, also applies to other wafer compositions described herein.

The p-n junction boundary is located where the front doped layer and back doped layer of the wafer meet. In an n-type solar cell, the back doped layer is doped with an electron donating n-type dopant and the front doped layer is doped with an electron accepting or hole donating p-type dopant. In a p-type solar cell, the back doped layer is doped with p-type dopant and the front doped layer is doped with n-type dopant. According to a preferred embodiment of the invention, a wafer with a p-n junction boundary is prepared by first providing a doped silicon substrate and then applying a doped layer of the opposite type to one face of that substrate.

The doped silicon substrate can be prepared by any method known in the art and considered suitable for the invention. Preferred sources of silicon substrates according to the invention include, but are not limited to, mono-crystalline silicon, multi-crystalline silicon, amorphous silicon and upgraded metallurgical silicon, most preferably mono-crystalline silicon or multi-crystalline silicon. Doping to form the doped silicon substrate can be carried out simultaneously by adding the dopant during the preparation of the silicon substrate, or it can be carried out in a subsequent step. Doping subsequent to the preparation of the silicon substrate can be carried out by gas diffusion epitaxy, for example. Doped silicon substrates are also readily commercially available. According to one embodiment, the initial doping of the silicon substrate may be carried out simultaneously to its formation by adding dopant to the silicon mix. According to another embodiment, the application of the front doped layer and the highly doped back layer, if present, may be carried out by gas-phase epitaxy. This gas phase epitaxy is preferably carried out at a temperature of at least about 500 °C, preferably at least about 600°C, and most preferably at least about 650°C. At the same time, the temperature is preferably no more than about 900°C, preferably no more than about 800°C, and most preferably no more than about 750°C. The gas phase epitaxy is preferably carried out at a pressure of at least about 2 kPa, preferably at least about 10 kPa, and most preferably at least about 40 kPa. At the same, the pressure is preferably no more than about 100 kPa, preferably no more than about 80 kPa, and most preferably no more than about 70 kPa.

It is known in the art that silicon substrates can exhibit a number of shapes, surface textures and sizes. The shape of the substrate may include cuboid, disc, wafer and irregular polyhedron, to name a few. According to a preferred embodiment of the invention, the wafer is a cuboid with two dimensions which are similar, preferably equal, and a third dimension which is significantly smaller than the other two dimensions. The third dimension may be at least 100 times smaller than the first two dimensions. Further, silicon substrates with rough surfaces are preferred. One way to assess the roughness of the substrate is to evaluate the surface roughness parameter for a sub-surface of the substrate, which is small in comparison to the total surface area of the substrate, preferably less than about one hundredth of the total surface area, and which is essentially planar. The value of the surface roughness parameter is given by the ratio of the area of the sub-surface to the area of a theoretical surface formed by projecting that sub-surface onto the flat plane best fitted to the sub-surface by minimizing mean square displacement. A higher value of the surface roughness parameter indicates a rougher, more irregular surface and a lower value of the surface roughness parameter indicates a smoother, more even surface. According to the invention, the surface roughness of the silicon substrate is preferably modified so as to produce an optimum balance between a number of factors including, but not limited to, light absorption and adhesion to the surface.

The two larger dimensions of the silicon substrate can be varied to suit the application required of the resultant solar cell. It is preferred according to the invention for the thickness of the silicon wafer to be below about 0.5 mm, more preferably below about 0.3 mm, and most preferably below about 0.2 mm. Some wafers have a minimum thickness of 0.01 mm or more.

It is preferred that the front doped layer be thin in comparison to the back doped layer. It is also preferred that the front doped layer have a thickness of at least about 0.1 µm, and preferably no more than about 10 µm, preferably no more than about 5 µm, and most preferably no more than about 2 µm.

A highly doped layer can be applied to the back face of the silicon substrate between the back doped layer and any further layers. Such a highly doped layer is of the same doping type as the back doped layer and such a layer is commonly denoted with a + (n+-type layers are applied to n-type back doped layers and p+-type layers are applied to p-type back doped layers). This highly doped back layer serves to assist metallization and improve electroconductive properties. It is preferred according to the invention for the highly doped back layer, if present, to have a thickness of at least 1 µm, and preferably no more than about 100 µm, preferably no more than about 50 µm and most preferably no more than about 15 µm.

### Dopants

Preferred dopants are those which, when added to the silicon wafer, form a p-n junction boundary by introducing electrons or holes into the band structure. It is preferred that the identity and concentration of these dopants is specifically selected so as to tune the band structure profile of the p-n junction and set the light absorption and conductivity profiles as required. Preferred p-type dopants include, but are not limited to, those which add holes to the silicon wafer band structure. All dopants known in the art and which are considered suitable in the context of the invention can be employed as p-type dopants. Preferred p-type dopants include, but are not limited to, trivalent elements, particularly those of group 13 of the periodic table. Preferred group 13 elements of the periodic table in this context include, but are not limited to, boron, aluminum, gallium, indium, thallium, or a combination of at least two thereof, wherein boron is particularly preferred.

Preferred n-type dopants are those which add electrons to the silicon wafer band structure. Preferred n-type dopants are elements of group 15 of the periodic table. Preferred group 15 elements of the periodic table in this context include, but are not limited to, nitrogen, phosphorus, arsenic, antimony, bismuth or a combination of at least two thereof, wherein phosphorus is particularly preferred.

As described above, the various doping levels of the p-n junction can be varied so as to tune the desired properties of the resulting solar cell. Doping levels are measured using secondary ion mass spectroscopy.

According to certain embodiments, the semiconductor substrate (i.e., silicon wafer) exhibits a sheet resistance above about 60 Ω/□, such as above about 65 Ω/□, 70 Ω/□, 90 Ω/□ or 100 Ω/□. For measuring the sheet resistance of a doped silicon wafer surface, the device "GP4-Test Pro" equipped with software package "GP-4 Test 1.6.6 Pro" (available from GP Solar GmbH) is used. For the measurement, the four point measuring principle is applied. The two outer probes apply a constant current and two inner probes measure the voltage. The sheet resistance is deduced using the Ohmic law in Ω/□. To determine the average sheet resistance, the measurement is performed on 25 equally distributed spots of the wafer. In an air conditioned room with a temperature of 22 ± 1 °C, all equipment and materials are equilibrated before the measurement. To perform the measurement, the "GP-Test.Pro" is equipped with a 4-point measuring head (Part Number 04.01.0018) with sharp tips in order to penetrate the anti-reflection and/or passivation layers. A current of 10 mA is applied. The measuring head is brought into contact with the non metalized wafer material and the measurement is started. After measuring 25 equally distributed spots on the wafer, the average sheet resistance is calculated in Ω/□.

### Solar Cell Structure

A contribution to achieving at least one of the above described objects is made by a solar cell obtainable from a process according to the invention. Preferred solar cells according to the invention are those which have a high efficiency, in terms of proportion of total energy of incident light converted into electrical energy output, and those which are light and durable. At a minimum, a solar cell includes: (i) front electrodes, (ii) a front doped layer, (iii) a p-n junction boundary, (iv) a back doped layer, and (v) soldering pads. The solar cell may also include additional layers for chemical/mechanical protection.

### Antireflective Layer

According to the invention, an antireflective layer may be applied as the outer layer before the electrode is applied to the front face of the solar cell. All antireflective layers known in the art and which are considered to be suitable in the context of the invention can be employed. Preferred antireflective layers are those which decrease the proportion of incident light reflected by the front face and increase the proportion of incident light crossing the front face to be absorbed by the wafer. Antireflective layers which give rise to a favorable absorption/reflection ratio, are susceptible to etching by the electroconductive composition, are otherwise resistant to the temperatures required for firing of the electroconductive composition, and do not contribute to increased recombination of electrons and holes in the vicinity of the electrode interface, are preferred. Preferred antireflective layers include, but are not limited to, SiNₓ, SiO₂, Al₂O₃, TiO₂ or mixtures of at least two thereof and/or combinations of at least two layers thereof. According to a preferred embodiment, the antireflective layer is SiNₓ, in particular where a silicon wafer is employed.

The thickness of antireflective layers is suited to the wavelength of the appropriate light. According to a preferred embodiment of the invention, the antireflective layers have a thickness of at least 20 nm, preferably at least 40 nm, and most preferably at least 60 nm. At the same time, the thickness is preferably no more than about 300 nm, more preferably no more than about 200 nm, and most preferably no more than about 90 nm.

### Passivation Layers

One or more passivation layers may be applied to the front and/or back side of the silicon wafer as an outer layer. The passivation layer(s) may be applied before the front electrode is formed, or before the antireflective layer is applied (if one is present). Preferred passivation layers are those which reduce the rate of electron/hole recombination in the vicinity of the electrode interface. Any passivation layer which is known in the art and which is considered to be suitable in the context of the invention can be employed. Preferred passivation layers according to the invention include, but are not limited to, silicon nitride, silicon dioxide and titanium dioxide. According to a more preferred embodiment, silicon nitride is used. It is preferred for the passivation layer to have a thickness of at least 0.1 nm, preferably at least 10 nm, and most preferably at least 30 nm. As the same time, the thickness is preferably no more than about 2 µm, preferably no more than about 1 µm, and most preferably no more than about 200 nm.

### Additional Protective Layers

In addition to the layers described above, further layers can be added for mechanical and chemical protection. The cell can be encapsulated to provide chemical protection. According to a preferred embodiment, transparent polymers, often referred to as transparent thermoplastic resins, are used as the encapsulation material, if such an encapsulation is present. Preferred transparent polymers in this context are silicon rubber and polyethylene vinyl acetate

(PVA). A transparent glass sheet may also be added to the front of the solar cell to provide mechanical protection to the front face of the cell. A back protecting material may be added to the back face of the solar cell to provide mechanical protection. Preferred back protecting materials are those having good mechanical properties and weather resistance. The preferred back protection material according to the invention is polyethylene terephthalate with a layer of polyvinyl fluoride. It is preferred for the back protecting material to be present underneath the encapsulation layer (in the event that both a back protection layer and encapsulation are present).

A frame material can be added to the outside of the solar cell to give mechanical support. Frame materials are well known in the art and any frame material considered suitable in the context of the invention may be employed. The preferred frame material according to the invention is aluminum.

### Method of Preparing a Solar Cell

A solar cell may be prepared by applying the electroconductive composition of the invention to an antireflection coating, such as silicon nitride, silicon oxide, titanium oxide or aluminum oxide, on the front side of a semiconductor substrate, such as a silicon wafer. A backside electroconductive composition is then applied to the backside of the solar cell to form soldering pads. An aluminum paste is then applied to the backside of the substrate, overlapping the edges of the soldering pads formed from the backside electroconductive composition, to form the BSF.

The electroconductive compositions may be applied in any manner known in the art and considered suitable in the context of the invention. Examples include, but are not limited to, impregnation, dipping, pouring, dripping on, injection, spraying, knife coating, curtain coating, brushing, screen printing, printing, or a combination of at least two thereof. Preferred printing techniques are ink-jet printing, screen printing, tampon printing, offset printing, relief printing or stencil printing or a combination of at least two thereof. It is preferred according to the invention that the electroconductive composition is applied by printing, preferably by screen printing. Specifically, the screens preferably have mesh opening with a diameter of at least about 10 µm, preferably at least about 20 µm. At the same time, the screens preferably have a mesh opening of no more than about 80 µm, preferably no more than about 60 µm, and most preferably no more than about 50 µm.

The substrate is then fired according to an appropriate profile. Firing is necessary to sinter the printed electroconductive composition so as to form solid electrodes. Firing is well known in the art and can be effected in any manner considered suitable in the context of the invention. It is preferred that firing be carried out above the T_{g} of the glass frit materials.

According to the invention, the maximum temperature set for firing is below about 900°C, preferably below about 860°C. Firing temperatures as low as about 770°C have been employed for obtaining solar cells. Firing temperatures should also allow for effective sintering of the metallic particles to be achieved. The firing temperature profile is typically set so as to enable the burnout of organic materials from the electroconductive composition. The firing step is typically carried out in air or in an oxygen-containing atmosphere in a belt furnace. It is preferred for firing to be carried out in a fast firing process with a total firing time of at least 30 seconds, and preferably at least 40 seconds. At the same time, the firing time is preferably no more than about 3 minutes, more preferably no more than about 2 minutes, and most preferably no more than about 1 minute. The time above 600°C is most preferably in a range from about 3 to 7 seconds. The substrate may reach a peak temperature in the range of about 700 to 900°C for a period of about 1 to 5 seconds. The firing may also be conducted at high transport rates, for example, about 100-700 cm/min, with resulting hold-up times of about 0.5 to 3 minutes. Multiple temperature zones, for example 3-12 zones, can be used to control the desired thermal profile.

Firing of electroconductive compositions on the front and back faces can be carried out simultaneously or sequentially. Simultaneous firing is appropriate if the electroconductive compositions applied to both faces have similar, preferably identical, optimum firing conditions. Where appropriate, it is preferred for firing to be carried out simultaneously. Where firing is carried out sequentially, it is preferable for the back electroconductive composition to be applied and fired first, followed by application and firing of the electroconductive composition to the front face of the substrate.

### Measuring Properties of Electroconductive Composition

The sample solar cell is characterized using a commercial IV-tester "cetisPV-CTL1" from Halm Elektronik GmbH. All parts of the measurement equipment as well as the solar cell to be tested were maintained at 25°C during electrical measurement. This temperature should be measured simultaneously on the cell surface during the actual measurement by a temperature probe. The Xe Arc lamp simulates the sunlight with a known AM1.5 intensity of 1000 W/m² on the cell surface. To bring the simulator to this intensity, the lamp is flashed several times within a short period of time until it reaches a stable level monitored by the "PVCTControl 4.313.0" software of the IV-tester. The Halm IV tester uses a multi-point contact method to measure current (I) and voltage (V) to determine the solar cell's IV-curve. To do so, the solar cell is placed between the multi-point contact probes in such a way that the probe fingers are in contact with the bus bars (i.e., printed lines) of the solar cell. The numbers of contact probe lines are adjusted to the number of bus bars on the cell surface. All electrical values were determined directly from this curve automatically by the implemented software package. As a reference standard, a calibrated solar cell from ISE Freiburg consisting of the same area dimensions, same wafer material, and processed using the same front side layout, was tested and the data was compared to the certificated values. At least five wafers processed in the very same way were measured and the data was interpreted by calculating the average of each value. The software PVCTControl 4.313.0 provides values for efficiency, fill factor, short circuit current, series resistance and open circuit voltage.

### Solar Cell Module

A plurality of solar cells according to the invention can be arranged spatially and electrically connected to form a collective arrangement called a module. Preferred modules according to the invention can have a number of arrangements, preferably a rectangular arrangement known as a solar panel. A large variety of ways to electrically connect solar cells, as well as a large variety of ways to mechanically arrange and fix such cells to form collective arrangements, are well known in the art. Preferred methods according to the invention are those which result in a low mass to power output ratio, low volume to power output ration, and high durability. Aluminum is the preferred material for mechanical fixing of solar cells according to the invention.

In one embodiment, multiple solar cells are connected in series and/or in parallel and the ends of the electrodes of the first cell and the last cell are preferably connected to output wiring. The solar cells are typically encapsulated in a transparent thermal plastic resin, such as silicon rubber or ethylene vinyl acetate. A transparent sheet of glass is placed on the front surface of the encapsulating transparent thermal plastic resin. A back protecting material, for example, a sheet of polyethylene terephthalate coated with a film of polyvinyl fluoride, is placed under the encapsulating thermal plastic resin. These layered materials may be heated in an appropriate vacuum furnace to remove air, and then integrated into one body by heating and pressing. Furthermore, since solar cells are typically left in the open air for a long time, it is desirable to cover the circumference of the solar cell with a frame material consisting of aluminum or the like.

The invention will now be described in conjunction with the following, non-limiting examples.

### Example 1

A set of exemplary coated inorganic particles were prepared. A leaded glass frit having a specific surface area of about 4 m²/g was first coated with various organic coatings. A first glass (G1) was coated with 1.5% oleic acid in 30 grams isopropanol acid (IPA); a second glass (G2) was coated with 1.5% oleic acid as ammonium oleate in 30 grams of a mixture of 33% IPA/67% deionized water; and a third glass (G3) was coated with 2% Disperbyk^{®}-110 in 30 grams of IPA, commercially available from BYK Additives & Instrument of Louisville, KY. All percentages are based upon wt% of the electroconductive paste composition.

Each of the coating mixtures was first prepared by mixing the above-referenced coating materials in the above-referenced solvents. About 16 grams of the leaded glass frit was then added to the coating mixture and mixed for about 15 minutes. The entire mixture was then poured onto a tray and dried at about 50°C to evaporate the solvent.

Exemplary electroconductive pastes were then prepared by mixing each of the coated glass frits, silver particles, and organic vehicle. Control pastes were prepared with uncoated glass frits. Two different organic vehicles were used to test the coating compatibility with different vehicle components. Vehicle 1 comprised about 84.4% solvent, 3.4% resin, and 12.2% additives. Vehicle 2 comprised 73.5% solvent, 4.2% resin, and 22.3% additives. Vehicle 2 comprised about 73.5% of a different solvent blend from Vehicle 1, about 4.2% resin, and about 22.3% additives (which also differ from Vehicle 1). The compositions of each exemplary paste and control paste are set forth in Table 1 below, with all percentages given in wt% of the paste composition.

**Table 1. Exemplary Paste Compositions having Organic Coated Glass Frits**

| | **Control 1** | **Control 2** | **P1** | **P2** | **P3** | **P4** |
|---|---|---|---|---|---|---|
| Silver | 89.4 | 89.2 | 89.4 | 89.2 | 89.4 | 89.2 |
| Uncoated Glass | 1.7 | 1.7 | - | - | - | - |
| G1 | - | - | 1.7 | | - | - |
| G2 | - | - | | 1.7 | - | - |
| G3 | - | - | - | - | 1.7 | 1.7 |
| Vehicle 1 | 8.9 | - | 8.9 | - | 8.9 | - |
| Vehicle 2 | - | 9.1 | - | 9.1 | - | 9.1 |

The mixture was then milled using a three-roll mill until it became a dispersed uniform paste. The viscosity of each exemplary and control paste was then measured according to the parameters set forth herein. The results are set forth in Table 2 below. Each exemplary paste and control paste was then screen printed onto multicrystalline silicon wafers having a sheet resistance of 90 Ω/□ at a speed of 150 mm/s, using screen 325 (mesh) * 0.9 (mil, wire diameter) * 0.6 (mil, emulsion thickness) * 40 µm (finger line opening) (Calendar screen). The pastes were screen printed to form three busbars and 85 finger lines on the surface of the silicon wafer. Each paste was flooded on mylar, and then four wafers were printed. A total of 30 flood cycles were run on mylar, four more wafers were printed, and then flood was assessed by slowing the print speed to 50 mm/s and printing on mylar. This last flood step was performed to assess the ability of the paste to flood under severe conditions. The printed wafers were then dried at about 150°C and fired at a profile with a peak temperature at about 770°C for a few seconds in a linear multi-zone infrared furnace.

The printed lines were then photographed and measured for analysis. As set forth in Table 2 below, the height and width of each finger line was measured along its length using a Zeta-200 Optical Profiler, manufactured by Zeta Instruments of San Jose, California. The aspect ratio was also calculated by dividing the average height by the average width of the lines. As set forth herein, the higher the aspect ratio, the better the electrical performance of the printed line.

The flood and transfer performance was visually inspected and rated accordingly. An indication of "full flood" means that 100% of the screen pattern was covered with paste after the flood cycle. A partial flood (e.g., 50%) means that 50% of the screen pattern was covered with paste after the flood cycle. Such values are determined by visual inspection. As set forth in the table below, the sufficiency of the transfer is provided in terms of the following scale: "+" denotes fair transfer; "++" denotes average transfer; "+++" denotes above average transfer; and "++++" denotes well above average transfer. The number of line breaks and low spots in the line (before and after the flood cycle) were counted by visually inspecting the printed line using electroluminescent (EL) imaging. Specifically, when viewing the printed line using EL imaging, complete line breaks appear as black streaks on the image, while low spots (incomplete paste transfer) appear as gray streaks.

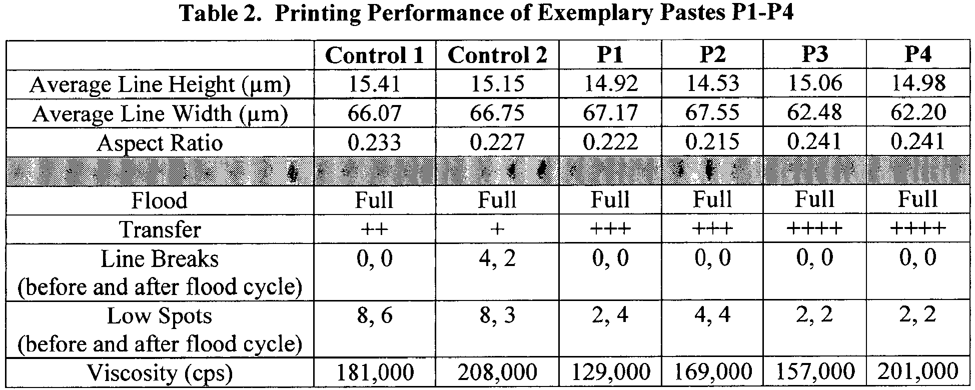

The exemplary pastes containing coated glass G3 (P3, P4) exhibited improved aspect ratio and transfer. Further, printed lines formed with these pastes had the least amount of low spots before and after the flood cycle. Pastes printed with coated glasses G1 and G2 also had a lesser amount of low spots as compared to the control pastes.

### Example 2

Exemplary pastes P3 and P4, as well as Control 1 and Control 2, were reevaluated after 14 days aging to ascertain the stability of the exemplary pastes. The printing performance was evaluated according to the same parameters of Example 1. The viscosity measurements were taken initially at the time of preparing the paste, and then after 14 days of aging. The results are set forth in Table 4 below.

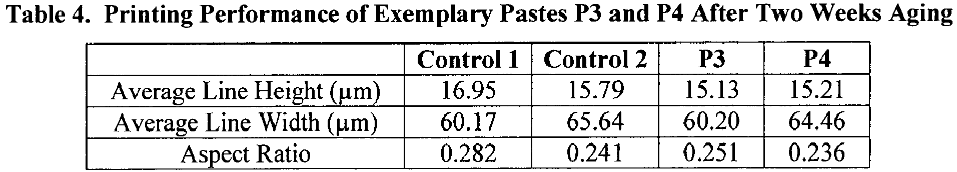

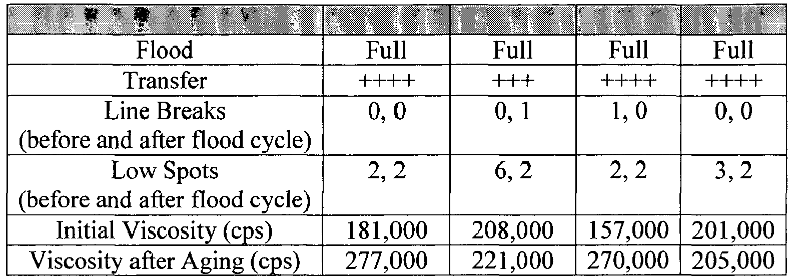

The electrical performance of solar cells printed with these pastes was also evaluated according to the parameters set forth herein. The software PVCTControl 4.260.0 provides values for efficiency (Eff, %), fill factor (FF, %), short circuit current (Isc, mA/cm²), series resistance under three standard lighting intensities (Rs3, mΩ), and open circuit voltage (Voc, V). The results are set forth in Table 5 below.

**Table 5. Electrical Performance of Exemplary Solar Cell with Pastes P3 and P4**

| | **Control 1** | **Control 2** | **P3** | **P4** |
|---|---|---|---|---|
| Eff (%) | 17.22 | 17.20 | 17.23 | 17.23 |
| FF (%) | 77.78 | 77.80 | 77.78 | 77.93 |
| Isc (mA/cm²) | 8.621 | 8.610 | 8.622 | 8.611 |
| Rs3 (Ω) | 0.00342 | 0.00335 | 0.00343 | 0.00338 |
| Voc (V) | 0.6250 | 0.6249 | 0.6254 | 0.6249 |

The finger lines printed with the exemplary pastes demonstrated comparable electrical performance compared to lines printed with the control pastes. As such, the presence of the coated glass had no detrimental effect on the electrical performance of the paste.

### Example 3

Another exemplary paste (P5), as well as a control paste (Control 3), was prepared according to the parameters set forth in Example 1. Paste P5 contained the same glass coating glass G3 (2% Disperbyk^{®}-110 in IPA). In this example, about 0.18 grams of the coating was mixed with about 17 grams IPA. To this, about 9 grams of leaded glass frit was added and the combination was mixed for about 15 minutes. The contents were then poured onto a try and dried at about 50°C to evaporate the solvent.

The exemplary and control paste contained Vehicle 1 from Example 1. The compositions of each paste are set forth in Table 6 below.

**Table 6. Exemplary Paste Compositions having Disperbyk^{®}-110 Coated Glass Frits**

| | **Control 3** | **P5** |
|---|---|---|
| Silver | 89.4 | 89.4 |
| Uncoated Glass | 1.7 | -- |
| G3 | -- | 1.7 |
| Vehicle 1 | 8.9 | 8.9 |

The viscosity of the exemplary and control pastes was then measured according to the parameters set forth herein. The results are set forth in Table 7 below. The exemplary and control paste were then screen printed onto multicrystalline silicon wafers having a sheet resistance of 90 Ω/□ with a more vigorous print method than that of Example 1. The pastes were printed at a speed of 200 mm/s, using screen 325 (mesh) * 0.9 (mil, wire diameter) * 0.6 (mil, emulsion thickness) * 40 µm (finger line opening) (Calendar screen). The pastes were screen printed in a pattern which formed three busbars and 85 finger lines on the surface of the silicon wafer. After ten flood cycles, each paste was printed onto two wafers, one at about 75 Newtons and the other at about 85 Newtons of force for each paste. The paste was then removed, a blank screen was installed, the paste was loaded, and the paste was cycled for 300 flood cycles, moving the paste back every 20 flood cycles. The paste was then removed, the screen was reinstalled, and two wafers were printed. The paste was allowed to sit on the screen with the pattern flooded for 15 minutes and two wafers were then printed. The paste was again allowed to sit on the screen with the pattern flooded for an additional 30 minutes and two wafers were then printed. This rigorous screen printing experiment assesses paste stability. The printed wafers were then dried at about 150°C and fired at a profile with a peak temperature at about 800°C for a few seconds in a linear multi-zone infrared furnace.

The printed lines were then photographed and measured for analysis according to the parameters in Example 1. The results are set forth in Table 7 below.

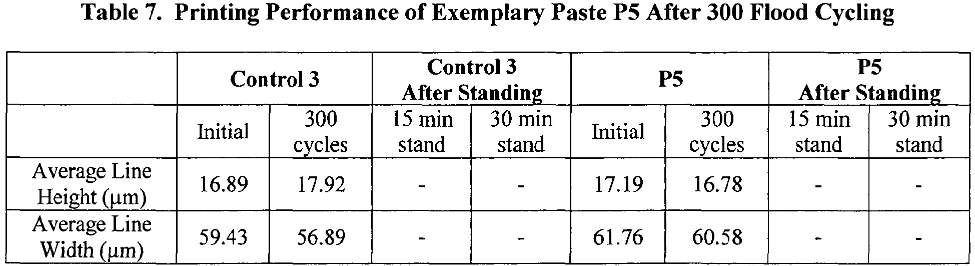

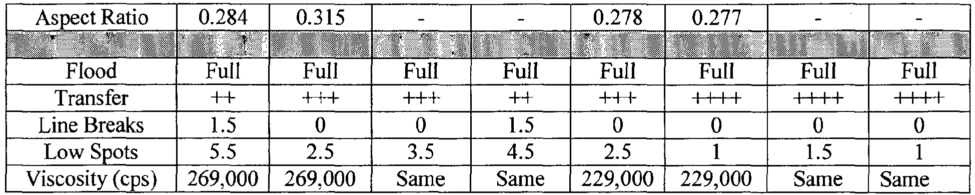

Exemplary paste P5 exhibited excellent transfer after 300 flood cycles, as well as after the 15 minute stand and the 30 minute stand. The printed line had no line breaks and less low spots than the control paste.

The electrical performance of solar cells printed with the exemplary and control pastes was also evaluated according to the parameters set forth in Example 2. The results are set forth in Table 8 below.

**Table 8. Electrical Performance of Exemplary Solar Cell with Paste P5**

| | **Control 3** | | **Control 3 After Standing** | | **P5** | | **P5 After Standing** | |
|---|---|---|---|---|---|---|---|---|
| | Initial | 300 cycles | 15 min stand | 30 min stand | Initial | 300 cycles | 15 min stand | 30 min stand |
| Eff (%) | 17.13 | 17.13 | 16.95 | 16.82 | 17.12 | 17.10 | 16.97 | 16.85 |
| FF (%) | 78.10 | 77.93 | 77.67 | 77.32 | 78.25 | 78.04 | 77.82 | 77.48 |
| Isc (mA/cm²) | 8.527 | 8.550 | 8.506 | 8.495 | 8.506 | 8.529 | 8.496 | 8.501 |
| Rs3 (Ω) | 0.00313 | 0.00326 | 0.00310 | 0.00316 | 0.00307 | 0.00316 | 0.00317 | 0.00309 |
| Voc (V) | 0.6259 | 0.6258 | 0.6243 | 0.6231 | 0.6260 | 0.6252 | 0.6246 | 0.6225 |

The finger lines printed with the exemplary paste demonstrated comparable electrical performance compared to lines printed with the control paste. As such, the presence of the coated glass had no detrimental effect on the electrical performance of the paste.

### Example 4

Another set of exemplary pastes may be prepared with the glasses set forth in Table 9 below according to the parameters set forth in Example 3. All values in Table 9 are expressed as mol% of the glass composition. In this example, the glass frits may be coated with about 2% Disperbyk^{®}-110 in IPA, available from BYK Additives & Instrument of Louisville, KY. The glass frit particles may be coated with the organic coating according to the parameters set forth in Example 3. Exemplary electroconductive pastes may then prepared by mixing each of the coated glass frits, silver particles, and organic vehicle (Vehicle 1), as set forth in Table 10 below, according to the parameters of Example 3.

**Table 9. Prophetic Glass Compositions (X1-X3)**

| | **X1** | **X2** | **X3** |
|---|---|---|---|
| PbO | - | 62.60 | - |
| Bi₂O₃ | - | - | 60.00 |
| SiO₂ | 24.23 | 28.40 | 35.00 |
| B₂O₃ | 24.05 | - | - |
| Al₂O₃ | 2.14 | 5.00 | - |
| K₂O | 0.87 | - | - |
| Na₂O | 12.03 | - | - |
| ZnO | 30.09 | - | 5.00 |
| Ta₂O₅ | - | 0.30 | - |
| TiO₂ | 3.65 | - | - |
| ZrO₂ | 2.95 | 1.20 | - |
| P₂O₅ | 2.5 | - | - |

**Table 10. Prophetic Paste Compositions Having Various Coated Glass Frits (X1-X3)**

| | **PX1** | **PX2** | **PX3** |
|---|---|---|---|
| Silver | 89.2 | 89.2 | 89.2 |
| Coated Glass | 1.7 | 1.7 | 1.7 |
| Organic Vehicle | 9.1 | 9.1 | 9.1 |

The exemplary pastes may then be screen printed onto multicrystalline silicon wafers according to the parameters of Example 1. The printed lines may then be photographed and analyzed according to the parameters of Example 1. The prophetic printing performance, namely the flood and transfer, of the exemplary pastes is set forth in Table 11 below. It is anticipated that the exemplary pastes containing the coated glass frits would exhibit complete flooding excellent transfer properties, as defined in Example 1.

**Table 11. Printing Performance of Prophetic Pastes PX1-PX3**

| | **PX1** | **PX2** | **PX3** |
|---|---|---|---|
| Flood | Full | Full | Full |
| Transfer | ++++ | ++++ | ++++ |

These and other advantages of the invention will be apparent to those skilled in the art from the foregoing specification. Accordingly, it will be recognized by those skilled in the art that changes or modifications may be made to the above described embodiments without departing from the broad inventive concepts of the invention. Specific dimensions of any particular embodiment are described for illustration purposes only. It should therefore be understood that this invention is not limited to the particular embodiments described herein, but is intended to include all changes and modifications that are within the scope and spirit of the invention.

### Further embodiments

| | |
|---|---|
| I | An inorganic oxide particle having an organic coating. |
| | |
| II | The inorganic oxide particle of embodiment I, wherein the organic coating has the ability to form hydrogen bonds or an organic compound having at least one group containing a heteroatom. |
| | |
| III | The inorganic oxide particle according to embodiment I or II, wherein the inorganic oxide particle comprises a glass frit particle. |
| | |
| IV | The inorganic oxide particle according to any of the preceding embodiments, wherein the organic coating is selected from the group of amines, fatty acids, copolymers with acidic groups, acrylic acids, phosphoric acid esters, polymer salts having an acid group, carboxylic acid esters having a hydroxyl group, fatty amides, carboxylic acids, phosphonic acids, organic acid anhydrides, acrylic copolymers, phosphates of a copolymer, alkyl ammonium salts of a block copolymer, modified acrylic block copolymers, modified acrylic block copolymers, their salts, and any combination of at least two thereof. |
| | |
| V | A process for preparing an organic coated inorganic oxide particle comprising forming an organic coating on the inorganic oxide particle. |
| VI | The process according embodiment V, wherein the organic coating has the ability to form hydrogen bonds or an organic compound having at least one group containing a heteroatom. |
| | |
| VII | A process for preparing an organic coated inorganic oxide particle, comprising: obtaining a mixture of at least one inorganic oxide particle and at least one coating agent in at least one solvent; agitating the mixture; and removing the solvent. |
| | |
| VIII | The process according to embodiment VII, wherein the step of agitating the mixture is performed using a stirred vessel, ball mill or media mill. |
| | |
| IX | The process according to embodiment VII or VIII, wherein the at least one coating agent has the ability to form hydrogen bonds or an organic compound having at least one group containing a heteroatom. |
| | |
| X | The process according to any of embodiments VII-IX, wherein the at least one coating agent is selected from the group of amines, fatty acids, copolymers with acidic groups, acrylic acids, phosphoric acid esters, polymer salts having an acid group, carboxylic acid esters having a hydroxyl group, fatty amides, carboxylic acids, phosphonic acids, organic acid anhydrides, acrylic copolymers, phosphates of a copolymer, alkyl ammonium salts of a block copolymer, modified acrylic block copolymers, modified acrylic block copolymers, their salts, and any combination of at least two thereof. |
| | |
| XI | The process according to any of embodiments VII-X, wherein the at least one solvent is selected from the group consisting of water, alcohols, ketones, ethers, esters, amides, amines, carboxylic acids, hydrocarbons, and any combination of at least two thereof. |
| | |
| XII | The process according to any of embodiments VII-XI, wherein the mixture is agitated at a temperature of at least about 5°C and no more than about 120°C. |
| XIII | The process according to any of embodiments VII-XII, wherein the solvent is removed by drying the mixture at a temperature of between about 25°C and 200°C. |
| | |
| XIV | The process according to any of embodiments VII-XIII, wherein the at least one inorganic oxide particle comprises at least one glass frit particle. |
| | |
| XV | The process according to any one of embodiments VII-XIV, wherein the at least one inorganic oxide particle has a particle size d₅₀ of at least about 0.1 µm, preferably at least 0.3 µm, and no more than about 50 µm, preferably no more than about 10 µm, more preferably no more than about 4 µm, and most preferably no more than about 2 µm. |
| | |
| XVI | The process according to any one of embodiments VII-XV, wherein the at least one inorganic oxide particle has a specific surface area of at least about 0.25 m²/g, preferably at least about 0.5 m²/g, and most preferably at least about 1 m²/g, and no more than about 100 m²/g, preferably no more than about 20 m²/g, and most preferably no more than about 10 m²/g. |
| | |
| XVII | The process according to any one of embodiments VI or IX-XVI, whereby the amount of heteroatoms (ppm on a weight basis) per unit specific surface area of the inorganic oxide particle is at least 10 ppm/(m²/g), preferably at least 50 ppm/(m²/g), and most preferably at least 100 ppm/(m²/g). |
| | |
| XVIII | An inorganic oxide particle prepared by a process according to any one of embodiments V-XVII. |
| | |
| XIX | Use of an inorganic oxide particle according to any one of embodiments I-IV and XVIII in a composition. |
| | |
| XX | The use according to embodiment XIX, wherein the composition is selected from an |
| | electroconductive composition, a resistor composition, a dielectric composition, a soldering composition, a decorative composition, a sealing composition, and any combination thereof. |
| | |
| XXI | A composition comprising inorganic oxide particles according to any one of embodiments I-IV and XVIII. |
| | |
| XXII | An electroconductive composition comprising: inorganic oxide particles according to any one of embodiments I-IV and XVIII; conductive metallic particles; and an organic vehicle. |
| | |
| XXIII | The electroconductive composition according to embodiment XXII, wherein the organic coating agent is at least about 0.05 wt% of the electroconductive composition, preferably at least about 0.25 wt%, most preferably at least about 0.5 wt%, and no more than about 10 wt%, preferably no more than about 7 wt%, and most preferably no more than about 4 wt%, based upon 100% total weight of the composition. |
| | |
| XXIV | The electroconductive composition according to embodiments XXII or XXIII, wherein the electroconductive comprises at least about 0.1 wt% inorganic oxide particles, preferably at least about 0.5 wt%, most preferably at least about 0.8 wt%, and no more than about 15 wt% inorganic component, preferably no more than about 10 wt%, and most preferably no more than about 5 wt%, based upon 100% total weight of the electroconductive composition. |
| | |
| XXV | The electroconductive composition according to any of embodiments XXII-XXIV, wherein the conductive metallic particles are at least one of silver, copper, gold, aluminum, nickel, platinum, palladium, molybdenum, and mixtures or alloys thereof, preferably silver. |
| | |
| XXVI | The electroconductive composition according to any of embodiments XXII-XXV, |
| | wherein the conductive metallic particles are at least 30 wt%, preferably at least 40 wt%, more preferably at least 70 wt%, and most preferably at least 80 wt%, and no more than about 99 wt%, preferably no more than about 95 wt%, based upon 100% total weight of the composition. |
| | |
| XXVII | The electroconductive composition according to any of embodiments XXII-XXVI, wherein the organic vehicle comprises an organic solvent and one or more of a binder, a surfactant, and a thixotropic agent, or any combination thereof. |
| | |
| XXVIII | The electroconductive composition according to any of embodiments XXII-XXVII, wherein the electroconductive composition comprises about 0.01 wt% organic vehicle, preferably at least about 1 wt%, most preferably at least about 5 wt%, and no more than about 70 wt% organic vehicle, preferably no more than about 55 wt%, and most preferably no more than about 20 wt%, based upon 100% total weight of the composition. |
| | |
| XXIX | A method comprising applying an electroconductive composition according to any one of embodiments XXII-XXVIII to at least one surface of a substrate. |
| | |
| XXX | The method according to embodiment XXIX, further comprising subjecting the electroconductive composition to one or more thermal treatment steps and/or one or more light curing steps. |
| | |
| XXXI | The method according to embodiment XXX, wherein the one or more thermal treatment steps are selected from drying, curing, firing, and any combination thereof in any order. |
| | |
| XXXII | The method according to embodiment XXX or XXXI, wherein the one or more thermal treatment steps are, independently, conducted at a temperature from about 20°C to about 1,000°C. |
| XXXIII | An electric device prepared by a method according to any one of embodiments XXIX-XXXII. |
| | |
| XXXIV | The electric device according to embodiment XXXIII, wherein the device is selected from an electric circuit, a solar cell, an LED, a display, a capacitor, a resistor, and any combination thereof. |
| | |
| XXXV | A solar cell produced by applying an electroconductive composition according to embodiments XXII-XXVIII to a silicon wafer and firing the silicon wafer. |
| | |
| XXXVI | A solar cell module comprising electrically interconnected solar cells according to embodiment XXXV. |

## Claims

1. An inorganic oxide particle having an organic coating.

2. The inorganic oxide particle of claim 1, wherein the organic coating has the ability to form hydrogen bonds or an organic compound having at least one group containing a heteroatom.

3. The inorganic oxide particle according to claim 1 or 2, wherein the inorganic oxide particle comprises a glass frit particle.

4. The inorganic oxide particle according to any of the preceding claims, wherein the organic coating is selected from the group of amines, fatty acids, copolymers with acidic groups, acrylic acids, phosphoric acid esters, polymer salts having an acid group, carboxylic acid esters having a hydroxyl group, fatty amides, carboxylic acids, phosphonic acids, organic acid anhydrides, acrylic copolymers, phosphates of a copolymer, alkyl ammonium salts of a block copolymer, modified acrylic block copolymers, modified acrylic block copolymers, their salts, and any combination of at least two thereof.

5. A process for preparing an organic coated inorganic oxide particle comprising forming an organic coating on the inorganic oxide particle.

6. A process for preparing an organic coated inorganic oxide particle, comprising:
obtaining a mixture of at least one inorganic oxide particle and at least one coating agent in at least one solvent;
agitating the mixture; and
removing the solvent.

7. The process according to claim 6, wherein the at least one inorganic oxide particle comprises at least one glass frit particle.

8. The process according to claims 6-7, wherein the at least one inorganic oxide particle has a specific surface area of at least about 0.25 m²/g, preferably at least about 0.5 m²/g, and most preferably at least about 1 m²/g, and no more than about 100 m²/g, preferably no more than about 20 m²/g, and most preferably no more than about 10 m²/g.

9. An inorganic oxide particle prepared by a process according to any one of claims 5-8.

10. Use of an inorganic oxide particle according to any one of claims 1-4 and 9 in a composition, wherein the composition is selected from an electroconductive composition, a resistor composition, a dielectric composition, a soldering composition, a decorative composition, a sealing composition, and any combination thereof.

11. A composition comprising inorganic oxide particles according to any one of claims 1-4 and 9.

12. An electroconductive composition comprising:
inorganic oxide particles according to any one of claims 1-4 and 9;
conductive metallic particles; and
an organic vehicle.

13. The electroconductive composition according to claim 12, wherein the electroconductive comprises at least about 0.1 wt% inorganic oxide particles, preferably at least about 0.5 wt%, most preferably at least about 0.8 wt%, and no more than about 15 wt% inorganic component, preferably no more than about 10 wt%, and most preferably no more than about 5 wt%, based upon 100% total weight of the electroconductive composition.

14. The electroconductive composition according to claims 12-13, wherein the conductive metallic particles are at least one of silver, copper, gold, aluminum, nickel, platinum, palladium, molybdenum, and mixtures or alloys thereof, preferably silver.

15. The electroconductive composition according to claims 12-14 wherein the conductive metallic particles are at least 30 wt%, preferably at least 40 wt%, more preferably at least 70 wt%, and most preferably at least 80 wt%, and no more than about 99 wt%, preferably no more than about 95 wt%, based upon 100% total weight of the composition.

16. The electroconductive composition according to any of claims 12-15, wherein the electroconductive composition comprises about 0.01 wt% organic vehicle, preferably at least about 1 wt%, most preferably at least about 5 wt%, and no more than about 70 wt% organic vehicle, preferably no more than about 55 wt%, and most preferably no more than about 20 wt%, based upon 100% total weight of the composition.

17. A method comprising applying an electroconductive composition according to any one of claims 12-16 to at least one surface of a substrate.

18. The method according to claim 17, further comprising subjecting the electroconductive composition to one or more thermal treatment steps and/or one or more light curing steps.

19. An electric device prepared by a method according to claims 17-18.

20. The electric device according to claim 19, wherein the device is selected from an electric circuit, a solar cell, an LED, a display, a capacitor, a resistor, and any combination thereof.
